# DEMANDE DE BREVET EUROPEEN

(11) **EP 1 075 021 A1**
(43) Date de publication de la demande: **07.02.2001**
(21) Numéro de dépôt: 00402211.7
(22) Date de dépôt: 02.08.2000
(51) Int. Cl.: H01L 21/56, H01L 25/10

(54) **Procédé d'obtention d'un module, à haute densité, à partir de composants électroniques, modulaires, encapsulés et module ainsi obtenu**

(30) Priorité: 02.08.1999 FR 9910011
(71) Demandeur: ALCATEL, 75008 Paris (FR)
(72) Inventeur: Vendier, Olivier, 31130 Balma (FR); Venet, Norbert, 31880 La Salvetat St. Gilles (FR); Calvel, Philippe, 31600 Muret (FR); Albinet, Stéphane, 31830 Plaisance du Touch (FR); Ester, Jean-Cyril, 31320 Vigoulet Auzil (FR); Huan, Marc, 31480 Cox (FR)
(74) Mandataire: Smith, Bradford Lee

(57) **Abrégé**

Procédé d'obtention d'un module (4) et module obtenu, à partir de composants électroniques, modulaires, encapsulés dans des boîtiers plats (lA) où les éléments constituant les composants sont noyés et d'où saillent latéralement des pattes de connexion (3A), les boîtiers étant empilés et noyés dans un bloc isolant correspondant à au moins un module et les pattes de connexion des boîtiers empilés venant affleurer en surface du bloc, au niveau d'au moins une face de ce bloc sur laquelle sont ménagées des pistes conductrices d'interconnexion et/ou des contacts de mise en liaison des pattes avec des moyens de connexion externes au module. Le procédé prévoit, préalablement à l'empilage des boîtiers, une opération de modification des pattes de connexion des boîtiers en vue d'en réduire l'encombrement et une opération de réduction de la hauteur des boîtiers par une action d'amincissement réalisée au niveau de leurs bases respectives.

## Description

L'invention concerne un procédé d'obtention d'un module, à haute densité, à partir de composants électroniques, modulaires, encapsulés. Elle concerne aussi les modules, composés de composants électroniques et en particulier les modules de mémoire de masse, obtenus par ce procédé.

Comme il est connu, de nombreux composants électroniques sont commercialisés sous forme modulaire encapsulée et notamment sous forme de boîtiers plastiques moulés dans lesquels les éléments constituant le composant sont noyés et sont dotés de pattes de connexion qui saillent latéralement hors des boîtiers. Dans une forme de réalisation usuelle, les pattes de connexion comportées par un boîtier sont cambrées de manière à venir en appui par une partie plate contre un circuit imprimé sur lequel le boîtier vient reposer. Tel est notamment le cas pour les composants encapsulés dans des boîtiers plats et minces, dits de type TSOP (Thin Small Outline Package en langue anglaise) qui permettent de réaliser des montages de faible épaisseur à un coût réduit par rapport aux techniques correspondantes antérieures.

Comme il est aussi bien connu, dans de nombreux domaines techniques et en particulier dans le domaine spatial, une part importante de la recherche est menée en vue de miniaturiser les équipements pour gagner en encombrement, poids et coût.

Un exemple de solution allant dans ce sens est divulgué par le document US-A-5885850 qui prévoit la réalisation de modules composés chacun d'un empilage de boîtiers plats de composants encapsulés qui est noyé dans un bloc de résine durcie de manière que les pattes des connexions de composants viennent affleurer en surface du bloc, au niveau d'au moins une face de ce bloc, et puissent être interconnectées entre elles et rendues accessibles de l'extérieur du bloc par des moyens de connexion appropriés connus. Cette technique dite MCM-V (Multiple Chips Module-Vertical) permet par exemple de réaliser des modules de mémoire de masse à haute densité par empilage vertical de boîtiers de mémoire, de type TSOP, de même constitution, dont les extrémités des pattes de connexion sont interconnectées au niveau de faces destinées à constituer les flancs des modules, ceux-ci étant d'allure cubique.

Toutefois, les boîtiers exploitables pour réaliser des modules par empilage ont été initialement prévus pour être isolément montés sur des circuits imprimés et ils présentent des épaisseurs relativement importantes, pour des raisons diverses liées aux conditions de leur fabrication, de leur utilisation et de leur destination. De telles épaisseurs sont notamment dues au besoin d'obtenir une rigidité des boîtiers qui permette de les manipuler, sans risque de détérioration des composants qu'ils contiennent, au cours des opérations conduisant à leur montage sur les circuits. Il est également nécessaire d'éliminer les risques de délamination de la matière de moulage en fond ce boîtier sous la couche, ordinairement en silicium, sur laquelle sont réalisés les composants.

Un des objets de l'invention est donc d'exploiter un procédé d'empilage tel que celui décrit dans le document US-A-5885850, évoqué plus haut, pour réaliser des modules permettant d'empiler un nombre de boîtiers nettement supérieur à celui obtenu jusqu'ici, pour des dimensions hors-tout équivalentes de module final.

En effet comme il est connu, la hauteur maximale d'un module susceptible d'être monté sur un circuit imprimé faisant partie d'un ensemble constitué de circuits imprimés montés en parallèle, par exemple au niveau d'un rack d'équipement, est limitée en fonction du pas de montage, généralement choisi normalisé, qui est prévu pour les circuits imprimés en parallèle. Un gain en densité de composants dans le plan vertical pour une même hauteur de module est donc susceptible de permettre d'importants gains en encombrement par carte, voire une réduction du nombre de cartes nécessaires.

L'invention propose donc un procédé d'obtention d'un module, à haute densité, à partir de composants électroniques, modulaires, encapsulés dans des boîtiers monoblocs plats où les éléments constituant les composants sont noyés et d'où saillent latéralement des pattes conductrices de connexion pour ces éléments. Il prévoit que les boîtiers sont empilés et noyés dans un bloc isolant correspondant à au moins un module, de manière que les pattes de connexion saillant des boîtiers empilés viennent affleurer en surface du bloc, au niveau d'au moins une face de ce bloc sur laquelle, selon les besoins, sont ménagées des pistes conductrices d'interconnexion entre pattes et/ou des contacts pour une mise en liaison des pattes avec des moyens de connexion externes au module.

L'invention, ses caractéristiques et ses avantages sont précisés dans la description qui suit en liaison avec les figures évoquées ci-dessous.

La figure 1 est une représentation schématique relative à un boîtier de composant électronique encapsulé connu.

La figure 2 est une représentation schématique d'un module composé de boîtiers amincis, selon l'invention.

La figure 3 est une représentation schématique d'une section d'une variante de module selon l'invention.

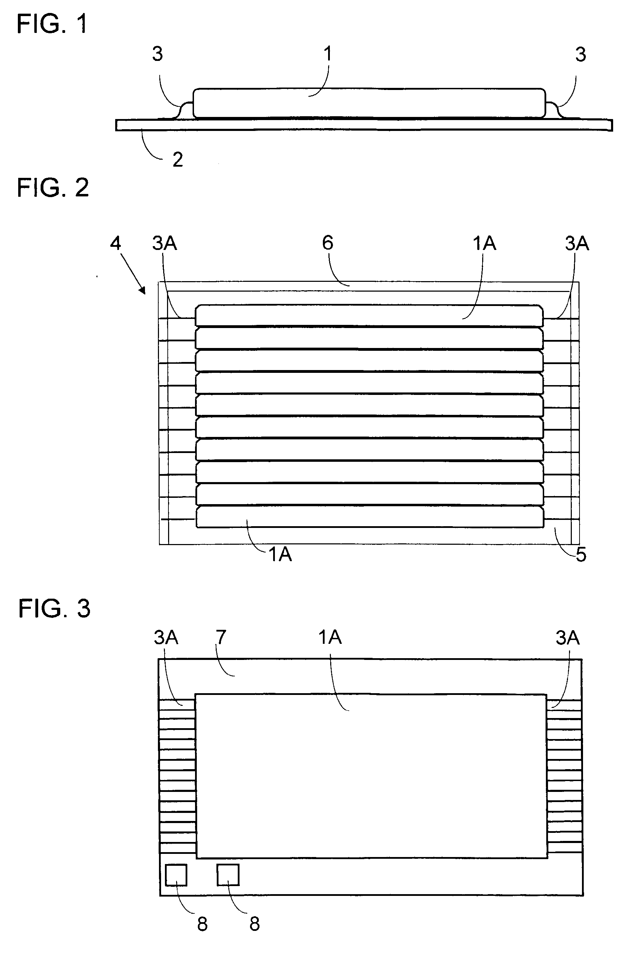

Le boîtier 1 schématisé sur la figure 1 est supposé être un classique boîtier rectangulaire plat, vu de côté, dans lequel sont encapsulés les éléments constitutifs d'un ou de plusieurs composants électroniques. Au moins certains de ces éléments sont usuellement réalisés sur un substrat qui s'étend parallèlement aux grandes faces du boîtier, une telle grande face de boîtier 1A étant montrée sur la figure 3. Ces grandes faces sont ici supposées constituer le dessus du boîtier, ainsi que la base par l'intermédiaire de laquelle il est prévu que ce boîtier vienne se plaquer contre un support 2, tel qu'un circuit imprimé.

Les éléments du ou des composants contenus dans le boîtier sont reliés à des pattes conductrices de connexion 3 qui saillent latéralement hors du boîtier au niveau d'au moins l'une des faces latérales de ce dernier. Dans une forme de réalisation classique ces pattes sont recourbées comme schématisé sur la figure 1 de manière à venir se plaquer chacune par une extrémité plate sur un plot de connexion complémentaire porté par la surface du support 2, de type circuit imprimé, contre lequel le boîtier est plaqué.

Des composants électroniques très divers et par exemple des composants modulaires de mémoire, sont ainsi encapsulés. Dans une forme de réalisation classique largement répandue, les éléments de ces composants sont noyés dans un matériau isolant qui est moulé et les opérations de moulage permettent de produire simultanément une série de boîtiers modulaires, de forme rectangulaire, qui sont séparés les uns des autres après la fin des opérations de moulage. Il est ainsi possible d'obtenir des boîtiers 1 plats et de très faible épaisseur, couramment dits de type TSOP, déjà évoqués plus haut.

Comme déjà indiqué ces boîtiers, d'allure rectangulaire, sont destinés à être manipulés isolément l'un de l'autre et ils doivent donc présenter une relative rigidité pour pouvoir être aisément manipulés. Pour cette raison et pour d'autres raisons techniques, leur épaisseur reste relativement importante et il est donc envisageable de la diminuer, si besoin est et en particulier s'il est prévu de les noyer dans un bloc après les y avoir empilés.

Or comme déjà indiqué plus haut, le document US-A-5885850 divulgue un procédé d'obtention de modules composés chacun d'un empilage de boîtiers plats de composants encapsulés que l'on noie dans un bloc de résine durcie. Ce procédé prévoit que les pattes des connexions de composants viennent affleurer en surface du bloc, au niveau d'au moins une face de ce bloc, et puissent être interconnectées entre elles et rendues accessibles de l'extérieur du bloc par des moyens de connexion appropriés connus. Cette technique dite MCM-V est bien entendu applicable à des boîtiers et notamment des boîtiers de type TSOP, tels qu'envisagés ci-dessus. L'emploi de tels boîtiers pour réaliser un empilage, après avoir été individuellement amincis, permet d'augmenter fortement la densité de composants par empilage à un coût modique, s'il est possible d'utiliser des composants couramment commercialisés après que ceux-ci aient subi des opérations visant à réduire leur encombrement et plus particulièrement leur épaisseur hors-tout, avant empilage.

Selon l'invention, ces opérations préparatoires sont prévues de deux types et conduisent l'une à une modification des pattes de connexion de manière à réduire leur encombrement à l'extérieur des boîtiers d'où elles saillent et l'autre à un amincissement des boîtiers.

L'amincissement des boîtiers, afin d'en réduire la hauteur, est réalisé par une élimination, au moins partielle et d'épaisseur uniforme qui est réalisée au niveau de la base de chacun. Cette élimination réalisée par exemple par abrasion est menée au niveau de la paroi de fond en matériau moulé qui est à la base de chaque boîtier et donc par le dessous de ce dernier. Cette élimination peut éventuellement conduire à l'élimination totale de la paroi de fond, la base du boîtier est alors essentiellement constituée par ce qui jouxtait préalablement cette paroi de fond et par exemple par la couche de substrat servant à la réalisation d'au moins certains des éléments du ou des composants du boîtier.

Dans une forme de réalisation, il est de plus prévu d'éliminer une épaisseur uniforme limitée de la couche de substrat qui jouxtait la paroi de fond avant que celle-ci ait été éliminée. Ceci permet donc une diminution supplémentaire de l'épaisseur de chaque boîtier et en conséquence l'empilage d'un nombre accru de boîtiers par module, pour une même hauteur de module par rapport à la situation antérieure. La figure 2 est une représentation schématique d'un module 4 obtenu par mise en oeuvre de la technique MCM-V avec des boîtiers 1' obtenus par mise en oeuvre du procédé selon l'invention. L'empilage de boîtiers amincis 1A est noyé dans un corps en résine moulé 5, supposé d'allure parallélépipédique rectangle, sur au moins une des faces duquel une métallisation 6 est réalisée. Cette métallisation est ensuite partiellement éliminée de manière déterminée pour ne pratiquement subsister que sous forme d'éléments conducteurs électriques et/ou thermiques, tels que de pistes conductrices, des plots conducteurs, des drains thermiques et/ou sous forme d'écran. Il est également prévu des contacts pour une mise en liaison d'au moins certaines des pattes de connexion des boîtiers, qui affleurent en surface du bloc que forme le module, avec des moyens de connexion externe non représentés par exemple de type billes conductrices.

Selon l'invention et comme énoncé plus haut, il est aussi prévu une modification des pattes de connexion saillant hors de chaque boîtier 1A, en vue d'en limiter l'encombrement et de faciliter les opérations d'amincissement et d'empilage des boîtiers 1A qui les comportent.

Dans une forme préférée de réalisation, les pattes de connexion saillant latéralement de chaque boîtier destiné à être aminci, sont soumises à une phase mécanique de mise à plat qui les amène à s'étendre selon un plan, ici supposé parallèle aux plans définis par les parois de base et de dessus du boîtier. Il est également prévu de raccourcir de manière homogène les pattes de connexion mises à plat des boîtiers, lorsque ceux-ci sont susceptibles d'être amincis pour faire partie d'un même empilage de boîtiers 1A. Ceci conduit par exemple à un raccourcissement identique de toutes les pattes de connexion destinées à saillir au niveau d'une même face d'un module 4. Il est bien entendu envisageable d'avoir à raccourcir de manière différente les pattes de connexion des boîtiers avant empilage de manière à obtenir que les pattes de connexion 3A obtenues après mise à plat et raccourcissement viennent affleurer à un même niveau par rapport à la face du bloc où elles apparaissent, notamment si les boîtiers empilés ne sont pas tous strictement identiques et si certains d'entre eux ont des grandes faces de taille légèrement différentes. Il est bien entendu possible d'effectuer un contrôle de bon fonctionnement, boîtier aminci par boîtier aminci, avant empilage pour éviter la mise en place d'un boîtier défectueux et préalablement au contrôle du bon fonctionnement du module obtenu.

Il est par ailleurs éventuellement prévu d'insérer un circuit imprimé 7, ou une tranche d'un cadre de connexion couramment désigné par "lead frame", entre deux boîtiers 1A successifs d'un empilage destiné à être noyé dans le bloc moulé d'un module 4, afin de répondre à différents besoins. Ceci peut notamment être prévu pour une interconnexion entre boîtiers à l'intérieur du bloc lui-même, et/ou encore pour permettre le montage de composants discrets 8, par exemple des composants CMS sur une tranche de cadre de connexion ou autour d'au moins d'un des deux boîtiers jouxtant le circuit imprimé, avant que l'ensemble soit noyé en un bloc de module.

## Revendications

1. Procédé d'obtention d'un module (4), à haute densité, à partir de composants électroniques, modulaires, encapsulés dans des boîtiers monoblocs plats (1) où les éléments constituant les composants sont noyés et d'où saillent latéralement des pattes conductrices de connexion (3) pour ces éléments, ledit procédé prévoyant que les boîtiers soient empilés et noyés dans un bloc isolant correspondant à au moins un module, de manière que les pattes de connexion saillant des boîtiers empilés viennent affleurer en surface du bloc, au niveau d'au moins une face de ce bloc sur laquelle, selon les besoins, sont ménagées des pistes conductrices d'interconnexion entre pattes et/ou des contacts pour une mise en liaison des pattes avec des moyens de connexion externes au module, ledit procédé étant caractérisé en ce qu'il prévoit préalablement à l'empilage des boîtiers (1A), une opération de modification des pattes de connexion des boîtiers en vue d'en réduire l'encombrement et une opération de réduction de la hauteur des boîtiers par une action d'amincissement réalisée au niveau de leurs bases respectives.

2. Procédé, selon la revendication 1, dans lequel il est prévu une réduction en hauteur des boîtiers par une élimination, au moins partielle et d'épaisseur uniforme, du matériau moulé constituant la paroi de base de chacun des boîtiers.

3. Procédé, selon la revendication 1, dans lequel il est prévu une réduction en hauteur des boîtiers, par élimination par en dessous du matériau constituant la paroi de base de chacun des boîtiers et d'une épaisseur uniforme limitée de la couche de substrat pour éléments de composant qui s'étend parallèlement à cette paroi de base dans chaque boîtier.

4. Procédé selon l'une des revendications 1 à 3, dans lequel l'opération de modification des pattes de connexion des boîtiers comporte une phase de mise à plat de chacune des pattes, préférablement selon un plan parallèle aux plans définis par les parois de base et de dessus du boîtier, et une phase de raccourcissement homogène des pattes.

5. Module réalisé sous la forme d'un bloc dans lequel est noyé un empilage de boîtiers modulaires (1A), monoblocs et plats, de composants électroniques où les éléments constituant les composants sont noyés et d'où saillent latéralement des pattes conductrices de connexion (3A) pour ces éléments, les dites pattes venant affleurer en surface du bloc isolant constituant le module, au niveau d'au moins une face de ce bloc sur laquelle, selon les besoins, sont ménagées des pistes conductrices d'interconnexion entre pattes et/ou des contacts pour une mise en liaison des pattes avec moyens de connexion externes au module, caractérisé en ce qu'il comporte un empilage réalisé à l'aide de boîtiers dont les hauteurs respectives ont été réduites par des actions d'amincissement qui ont été réalisées au niveau de leurs bases respectives, avant empilage et qui ont préférablement conduit, à une élimination par le dessous du matériau de la paroi de base formant fond et d'une épaisseur limitée de la couche de substrat pour éléments de composant disposée parallèlement aux parois de base et de dessus du boîtier.

6. Module, selon la revendication 5, comportant au moins un circuit imprimé (7) ou une tranche de cadre de connexion intercalé(e) entre deux boîtiers (1A) empilés pour une interconnexion entre boîtiers et/ou pour montage de composants discrets (8) sur une tranche ou autour d'au moins un des boîtiers entre lesquels ce circuit est intercalé dans le bloc que constitue le module (4).

7. Module, selon l'une des revendications 5, 6, constitué sous la forme d'un bloc contenant un empilage de boîtiers amincis (1A) d'au moins approximativement mêmes dimensions, dont les pattes de connexion latérales saillantes (3A) viennent affleurer en surface du bloc, au niveau d'au moins une face de ce bloc, et sont disposées à plat dans des plans parallèles dont l'orientation est au moins approximativement parallèle aux plans que définissent la base et le dessus de chacun des boîtiers empilés.
